# EUROPEAN PATENT SPECIFICATION

(11) **EP 3 872 879 B1**
(45) Date of publication and mention of the grant of the patent: **27.08.2025**
(21) Application number: 18939870.4
(22) Date of filing: 15.11.2018
(51) Int. Cl.: H10N 50/10

(54) **MAGNETO-RESISTIVE RANDOM STORAGE UNIT**
MAGNETORESISTIVE SPEICHERANORDNUNGSEINHEIT
UNITÉ DE STOCKAGE MAGNÉTO-RÉSISTIF

(43) Date of publication of application: 01.09.2021
(73) Proprietor: Huawei Technologies Co., Ltd., Shenzhen, Guangdong 518129 (CN)
(72) Inventor: XU, Jeffrey Junhao, Shenzhen, Guangdong 518129 (CN); YANG, Huan, Shenzhen, Guangdong 518129 (CN)
(74) Representative: Maiwald GmbH
(86) International application number: PCT/CN2018/115711
(87) International publication number: WO 2020/097872

(56) References cited:
- CN-A- 102 683 580
- CN-A- 105 449 097
- CN-A- 107 221 596
- US-A1- 2008 232 002
- US-A1- 2011 233 698
- US-A1- 2017 345 868
- US-A1- 2017 345 868

## Description

### TECHNICAL FIELD

This application relates to the field of storage, and in particular, to a magneto-resistive random memory cell, a magneto-resistive random access memory, and an access method.

### BACKGROUND

A magneto-resistive random access memory (MRAM) is a non-volatile memory (non-volatile memory), and records logical states "0" and "1" by using a magnetoresistance difference caused by a difference in magnetization directions. If an external magnetic field remains unchanged, a magnetization direction remains unchanged. Therefore, when maintaining data, the magneto-resistive random access memory does not need to perform a refreshing operation all the time, and therefore has an advantage of low power consumption. A representative magneto-resistive random access memory is a spin-torque-transfer (spin-torque-transfer, STT) MRAM, and may be used as a third-layer or fourth-layer cache.

The magneto-resistive random access memory may perform a write operation in a current control manner or a voltage control manner. A write operation performed by using an excessively large current causes excessive power consumption, and a decrease in the current causes a slower write operation. Therefore, a magneto-resistive random access memory that performs a write operation in a voltage control manner is a research focus in the industry. When a write operation is performed in a voltage control manner, a voltage of an appropriate magnitude and direction is applied to two sides of a magnetic tunnel junction, so that a magnetic moment of a free ferromagnetic layer in a magneto-resistive random access memory is reversed to a specified direction, to perform an operation of writing "0" or writing "1". In this manner, the magneto-resistive random access memory may have a higher write operation speed and lower power consumption. However, when the write operation is performed in a voltage control manner, to avoid generating an excessively large leakage current, a thickness of a magnetic tunnel barrier becomes larger, resulting in an increase in resistance. Consequently, a relatively high resistance-capacitance (resistance-capacitance, RC) delay is caused. This causes a decrease in a read speed of the magneto-resistive random access memory.
US2017345868 provides a DMTJ structure for sub-25nm designs.
US20110233698 also provides a magnetic memory device. US20080232002 discloses a magnetic tunnel junction structure having a tunnel barrier positioned between a fixed ferromagnetic layer and a free ferromagnetic layer. The tunnel barrier includes a first barrier layer contacting either the fixed ferromagnetic layer or the free ferromagnetic layer. A second barrier layer, which contacts the first barrier layer, has a lower barrier height than the first barrier layer.

### SUMMARY

This application provides a magneto-resistive random memory cell, a magneto-resistive random access memory, and an access method, to increase an access speed of the memory.

According to a first aspect, a magneto-resistive random memory cell is provided, including: a fixed ferromagnetic layer, a free ferromagnetic layer, and a magnetic tunnel barrier, where the magnetic tunnel barrier is located between the fixed ferromagnetic layer and the free ferromagnetic layer and includes a double-barrier quantum well including a first barrier layer, a conducting layer, and a second barrier layer.

In this embodiment of this application, a new structure of a magneto-resistive random memory cell and a magneto-resistive random access memory is provided. In the structure, a double-barrier quantum well structure is used to replace a conventional single-barrier magnetic tunnel barrier structure, and the structure uses a feature of negative differential resistance of the double-barrier quantum well. A voltage of a write operation is set to be greater than that of a read operation, to meet a requirement of optimizing performance of the write operation. In addition, because a current corresponding to the voltage of the read operation is relatively large, and a corresponding resistance value is relatively small, impact of the RC delay on a speed of the read operation is alleviated.

With reference to the first aspect, in a possible implementation, the first barrier layer and the second barrier layer are made of a dielectric, and the conducting layer is made of a conducting material.

With reference to the first aspect, in a possible implementation, the first barrier layer and the second barrier layer are made of crystalline oxide.

With reference to the first aspect, in a possible implementation, a material used for the first barrier layer and the second barrier layer includes MgO, AlO, AlN, BN, or SiO₂.

With reference to the first aspect, in a possible implementation, a material used for the conducting material includes a ferromagnetic material.

With reference to the first aspect, in a possible implementation, a material used for the conducting material includes CoFeB, CoFe, Co, or Fe.

With reference to the first aspect, in a possible implementation, the magnetic tunnel barrier is of a symmetrical structure.

With reference to the first aspect, in a possible implementation, when a negative first voltage is applied to a direction from the free ferromagnetic layer to the fixed ferromagnetic layer, a magnetic moment of the free ferromagnetic layer is reversed; or when a positive second voltage is applied to a direction from the free ferromagnetic layer to the fixed ferromagnetic layer, a magnetic tunnel junction including the fixed ferromagnetic layer, the free ferromagnetic layer, and the magnetic tunnel barrier is conducted, where an absolute value of the first voltage is greater than an absolute value of the second voltage.

With reference to the first aspect, in a possible implementation, a thickness of the first barrier layer is from 0.5 nm to 2 nm.

With reference to the first aspect, in a possible implementation, a thickness of the second barrier layer is from 0.5 nm to 2 nm.

With reference to the first aspect, in a possible implementation, a thickness of the conducting layer is from 0.5 nm to 2 nm.

According to a second aspect, a magneto-resistive random access memory is provided. The magneto-resistive random access memory includes the magneto-resistive random memory cell according to the first aspect or in any possible implementation of the first aspect.

According to a third aspect, a method for accessing a magneto-resistive random memory cell is provided. The magneto-resistive random memory cell includes: a fixed ferromagnetic layer, a free ferromagnetic layer, and a magnetic tunnel barrier, where the magnetic tunnel barrier is located between the fixed ferromagnetic layer and the free ferromagnetic layer and includes a double-barrier quantum wellincluding a first barrier layer, a conducting layer, and a second barrier layer. The method includes: when a write operation is performed, applying a negative first voltage to a direction from the free ferromagnetic layer to the fixed ferromagnetic layer; or when a read operation is performed, applying a positive second voltage to a direction from the free ferromagnetic layer to the fixed ferromagnetic layer, where an absolute value of the first voltage is greater than an absolute value of the second voltage.

According to a fourth aspect, an integrated circuit is provided, including the magneto-resistive random memory cell according to the first aspect or in any possible implementation of the first aspect.

According to a fifth aspect, a chip is provided, including the magneto-resistive random memory cell according to the first aspect or in any possible implementation of the first aspect.

According to a sixth aspect, an apparatus for accessing a magneto-resistive random memory cell is provided. The apparatus includes a unit configured to perform the method in the third aspect.

According to a seventh aspect, a computer program product is provided. The computer program product includes computer program code; and when the computer program code is run, the method in the third aspect is performed.

According to an eighth aspect, a computer-readable storage medium is provided. The computer-readable storage medium stores a computer program; and when the computer program is run, the method in the third aspect is implemented.

### BRIEF DESCRIPTION OF DRAWINGS

FIG. 1 is a schematic structural diagram of a magneto-resistive random memory cell that performs a write operation in a voltage control manner according to an embodiment of this application;
FIG. 2 is a schematic structural diagram of a magneto-resistive random memory cell according to an embodiment of the present invention;
FIG. 3 is a schematic diagram of distribution of energy levels of a double-barrier quantum well;
FIG. 4 shows voltage-current characteristic curves of a double-barrier quantum well;
FIG. 5 shows a voltage-current characteristic curve of another double-barrier quantum well;
FIG. 6 is a schematic diagram of a write operation of a magneto-resistive random memory cell according to an embodiment of this application; and
FIG. 7 is a schematic diagram of a read operation of a magneto-resistive random memory cell according to an embodiment of this application.

### DESCRIPTION OF EMBODIMENTS

The following describes technical solutions of this application with reference to accompanying drawings.

A magneto-resistive random access memory that performs a write operation in a voltage control manner according to the embodiments of this application is described first. Optionally, an MRAM that performs a write operation in a voltage control manner may also be referred to as a voltage-controlled magnetic anisotropy magnetoresistive random access memory (voltage-controlled magnetic anisotropy MRAM, VCMA-MRAM).

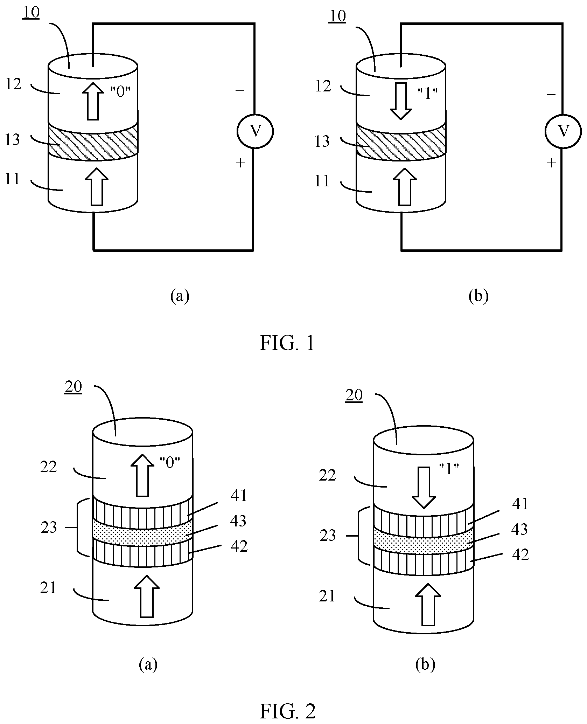

FIG. 1 is a schematic structural diagram of a magneto-resistive random memory cell 10 that performs a write operation in a voltage control manner. A core part of the magneto-resistive random access memory is a magneto-resistive random memory cell. As shown in FIG. 1, the magneto-resistive random memory cell 10 may include a magnetic tunnel junction (magnetic tunnel junction) including a fixed ferromagnetic layer 11, a magnetic tunnel barrier 13, and a free ferromagnetic layer 12. The magnetic tunnel barrier 13 may also be referred to as a magnetic tunnel barrier layer. A magnetic moment of the fixed ferromagnetic layer 11 is fixed, and a magnetic moment of the free ferromagnetic layer 12 is reversible. An arrow in FIG. 1 represents a direction of a magnetic moment in the fixed ferromagnetic layer 11 or the free ferromagnetic layer 12. Therefore, states may be respectively recorded as logical states "0" and "1" based on a magnetoresistance difference caused by a difference in a magnetic moment direction of the free ferromagnetic layer 12. For example, as shown in (a) of FIG. 1, if magnetic moment directions of the fixed ferromagnetic layer 11 and the free ferromagnetic layer 12 are the same, a resistance value of the magnetic tunnel junction is relatively small, and this state may be recorded as a logical state "0". As shown in (b) of FIG. 1, if the magnetic moment directions of the fixed ferromagnetic layer 11 and the free ferromagnetic layer 12 are opposite, the resistance value of the magnetic tunnel junction is relatively large, and this state may be recorded as a logical state "1". In this example, not part of the invention, that the logical state "0" or "1" corresponds to the small resistance value or the large resistance value of the magnetic tunnel junction is merely an example. During an actual operation, a correspondence between a logical state and a resistance value may be logically designed based on requirements, and a correspondence between a logical state and a resistance value of the magnetic tunnel junction may be even changed from a physical result by using a device such as a phase inverter. A working principle of performing a write operation in a voltage control manner is as follows: A voltage of an appropriate magnitude and direction is applied to two sides of the foregoing magnetic tunnel junction, so that negative charges are accumulated on interfaces of the free ferromagnetic layer 12 and the magnetic tunnel barrier 13, to change magnetic anisotropy of an interface of the free ferromagnetic layer 12, to make a magnetic moment direction of the free ferromagnetic layer 12 reserved and complete the write operation. It should be noted that, in both an operation of writing "0" and an operation of writing "1", directions of the voltage applied to the two sides of the magnetic tunnel junction are the same. Each time a voltage of an appropriate magnitude and direction is applied, a magnetic moment of the free ferromagnetic layer is reserved once, a magnetoresistance value changes, and then a logical state corresponding to the magnetic tunnel junction is switched once. For example, the logical state is changed from the logical state "0" to the logical state "1", or from the logical state "1" to the logical state "0".

Still referring to FIG. 1, in an example, when the magneto-resistive random memory cell 10 is in the logical state "0", the magnetic moment of the free ferromagnetic layer 12 is the same as that of the fixed ferromagnetic layer 11, and resistance of the magnetic tunnel junction is relatively small. Assuming that an end of the free ferromagnetic layer 12 is connected to a negative electrode of a power supply, and an end of the fixed ferromagnetic layer 11 is connected to a positive electrode of the power supply, a voltage of an appropriate magnitude is applied to two ends of the magnetic tunnel junction, so that the magnetic moment of the free ferromagnetic layer 12 can be reversed. After the magnetic moment is reversed, the magnetic moment direction of the free ferromagnetic layer 12 is opposite to that of the fixed ferromagnetic layer 11, the resistance of the magnetic tunnel junction is relatively large, and the logical state of the magneto-resistive random memory cell is switched to "1".

It should be noted that, to accumulate sufficient charges on the interface of the free ferromagnetic layer, a relatively large leakage current cannot pass through the magnetic tunnel barrier when a write operation is performed. When a thickness of the magnetic tunnel barrier is determinate, to generate sufficient charges on the interface of the free ferromagnetic layer, a maximum value of a write operation voltage needs to be set to meet a condition that no obvious leakage current is generated. When a maximum write operation voltage is not exceeded, a larger write operation voltage indicates a higher speed of the write operation and a lower error rate of the write operation. Therefore, the write operation voltage is expected to be increased to the greatest extent. For example, in an ideal situation, the write operation voltage may reach a power supply voltage V_{DD} of a logic device of a chip. For the read operation, a voltage of the read operation needs to be greater than that of the write operation, so that a voltage applied to the magnetic tunnel junction can generate a current flowing through the magnetic tunnel junction. Whether the magnetic tunnel junction is in the state "0" corresponding to the low resistance value or in the state "1" corresponding to the high resistance value may be determined based on a current value. In an ideal state, the voltage of the read operation is expected not to exceed the power supply voltage V_{DD} of the chip, or otherwise, another power supply needs to be provided to supply power for the read operation. Therefore, a current problem is: To meet write operation optimization and set the write operation voltage to the power supply voltage V_{DD}, because the read operation voltage needs to be greater than the write operation voltage, another power supply needs to be provided to supply power for the read operation, increasing complexity of circuit design. In consideration of simplifying circuit design, if the read operation voltage is set to the power supply voltage V_{DD}, and the write operation voltage is set to be less than the power supply voltage V_{DD}, performance of the write operation may be affected and cannot be better optimized.

In addition, compared with a conventional magneto-resistive random access memory that performs a write operation in a current control manner, the magneto-resistive random access memory that performs a write operation in a voltage control manner has a thicker magnetic tunnel barrier. Therefore, for devices with a same size, a resistance value of the magnetic tunnel junction of the voltage-controlled magneto-resistive random access memory is larger. During the read operation, due to an RC delay, excessively large magnetic tunnel junction resistance affects a speed of the read operation. For example, a thickness of a magnetic tunnel barrier of a VCMA-MRAM is usually approximately 1.5 nanometers (nanometer, nm), and a thickness of a magnetic tunnel barrier of an STT-MRAM is usually approximately 1 nm. For devices with a same size, resistance of the magnetic tunnel junction of the VCMA-MRAM is approximately 10 times that of the magnetic tunnel junction of the STT-MRAM.

To resolve the foregoing problems, namely, the problem that optimum voltage setting values of the write operation and the read operation of the magneto-resistive random access memory that performs the write operation in the voltage control manner are contradictory, and the problem that the speed of the read operation is relatively low, an embodiment of this application provides a new structure of a magneto-resistive random memory cell and a magneto-resistive random access memory. In the structure, a double-barrier quantum well structure is used to replace a conventional single-barrier magnetic tunnel barrier structure, to form a magnetic tunnel junction with a resonant tunneling effect.

FIG. 2 is a schematic structural diagram of a magneto-resistive random memory cell 20 according to an embodiment of the present invention. (a) of FIG. 2 describes a scenario in which a logical state is "0" and (b) of FIG. 2 describes a scenario in which the logical state is "1". A hollow arrow in FIG. 2 represents a direction of a magnetic moment in a fixed ferromagnetic layer 21 or a free ferromagnetic layer 22. As shown in FIG. 2, the magneto-resistive random memory cell 20 includes:
the fixed ferromagnetic layer 21, the free ferromagnetic layer 22, and a magnetic tunnel barrier 23, where the magnetic tunnel barrier 23 is located between the fixed ferromagnetic layer 21 and the free ferromagnetic layer 22, and includes a double-barrier quantum wellincluding a first barrier layer 41, a conducting layer 43, and a second barrier layer 42, and the conducting layer 43 is disposed between the first barrier layer 41 and the second barrier layer 42.

The fixed ferromagnetic layer 21 has a fixed magnetic moment, and the free ferromagnetic layer 22 has a reversible magnetic moment.

Optionally, interfaces of the fixed ferromagnetic layer 21, the magnetic tunnel barrier 23, and the free ferromagnetic layer 22 are in contact with each other. Optionally, an interface at a joint between the free ferromagnetic layer 22 and the magnetic tunnel barrier 23 may be processed, to increase magnetic anisotropy of the free ferromagnetic layer 22. For example, metal doping may be performed on the interface at the joint between the free ferromagnetic layer 22 and the magnetic tunnel barrier 23.

The double-barrier quantum well may be referred to as a double-barrier quantum well or a resonant tunneling barrier, or may be briefly referred to as a quantum well in the embodiments of this application, and may be understood as a barrier structure with a resonant tunneling effect. A principle of the resonant tunneling effect is that energy levels in a quantum well with a limited barrier height are distributed discontinuously. It is assumed that a first quantum well energy level is E₁, and magnitudes and distribution of quantum well energy levels may be adjusted based on a barrier height V₀ of the quantum well, a barrier width D of the quantum well, and a width L of the quantum well. Therefore, energy of carriers (for example, electrons) in the quantum well is also distributed discontinuously, and lowest energy of the carriers is E₁. When a voltage V_{bias} on two ends of the quantum well is relatively low, a Fermi level E_{F} of electrons is less than E₁, and only energy of a very few thermally excited electrons can reach E₁. According to a quantum effect, only the very few electrons whose energy is equal to E₁ can pass through the quantum well through a tunneling effect. That is, when the voltage V_{bias} on the two ends of the quantum well is relatively low, the Fermi level E_{F} of electrons is less than E₁, and a current passing through the quantum well is very small. When the voltage V_{bias} on the two ends of the quantum well increases, a quantity of electrons whose energy is equal to E₁ increases, a quantity of electrons passing through the quantum well through the tunneling effect correspondingly increases, and the current passing through the quantum well also correspondingly increases. When the voltage V_{bias} on the two ends of the quantum well continues increasing, to make the Fermi level E_{F} of electrons achieve E₄, the quantity of electrons whose energy is equal to E₁ reaches a maximum value, and the current passing through the quantum well correspondingly reach a local maximum value. In this case, the voltage V_{bias} (eV_{bias} = E₁) is a resonant voltage. When the voltage V_{bias} on the two ends of the quantum well continues increasing, the quantity of electrons whose energy is equal to E₁ is reduced. Therefore, the current passing through the quantum well correspondingly decreases, and reaches a minimum value. When the voltage V_{bias} on the two ends of the quantum well is greater than the height V₀ of the quantum well, the current passing through the quantum well starts to increase with the increase of the voltage V_{bias} on the two ends of the quantum well, and exceeds the local maximum value.

Optionally, the foregoing quantum well may be a metal quantum well. In other words, the conducting layer 43 may be made of metal or magnetic metal. For example, the conducting layer may be made of a metal material or a metal compound such as cobalt iron boron (CoFeB), cobalt iron (CoFe), iron (Fe), cobalt (Co), platinum (Pt), or tantalum (Ta).

Alternatively, the quantum well may be a semiconductor quantum well. In other words, the conducting layer 43 may be made of a magnetic or non-magnetic semiconductor. For example, the conducting layer may be made of any one of the following: silicon (Si), silicon germanium (SiGe), germanium (Ge), II-VI compounds, III-V compounds, or another compound semiconductor material.

The first barrier layer 41 and the second barrier layer 42 are made of a dielectric. A type of the dielectric is not limited in this embodiment of this application. For example, the dielectric may be oxide in a crystalline state or crystalline metal oxide, or may be oxide in an amorphous state, or a dielectric of another type. For example, the dielectric may be magnesium oxide (MgO) in a crystalline state, or may be aluminum oxide (AlO), aluminum nitride (AlN), boron nitride (BN), silicon oxide (SiO₂), or the like.

Optionally, the fixed ferromagnetic layer 21 and the free ferromagnetic layer 22 may be made of ferromagnetic metal. For example, the fixed ferromagnetic layer 21 and the free ferromagnetic layer 22 may be made of a ferromagnetic material such as cobalt iron boron (CoFeB), cobalt iron (CoFe), cobalt (Co), or iron (Fe).

In an example, the first barrier layer 41 and the second barrier layer 42 are made of magnesium oxide (MgO). The fixed ferromagnetic layer 21, the free ferromagnetic layer 22, and the conducting layer 43 are made of a ferromagnetic material such as cobalt iron boron (CoFeB), cobalt iron (CoFe), cobalt (Co), or iron (Fe). As an example instead of a limitation, thicknesses of the first barrier layer 41 and the second barrier layer 42 made of MgO may be from 0.5 nm to 2 nm, and a thickness of the conducting layer 43 made of CoFeB may be from 0.5 nm to 2 nm. A person skilled in the art can understand that, based on different materials or different requirements for performance of the magnetic tunnel barrier, thicknesses of the first barrier layer 41, the second barrier layer 42, and the conducting layer 43 may alternatively be in another value range, but need to meet a condition of forming a quantum well whose energy levels are discontinuous.

Optionally, if the foregoing quantum well is a semiconductor quantum well, materials of which the first barrier layer 41, the conducting layer 43, and the second barrier layer 42 are made need to be compatible with a semiconductor material. For example, when the conducting layer 43 of the semiconductor quantum well is made of silicon (Si), silicon oxide (SiO₂) may be used as a material of the first barrier layer 41 and the second barrier layer 42.

Optionally, the foregoing magnetic tunnel barrier may be of a symmetrical structure. For example, sizes of the first barrier layer 41 and the second barrier layer 42 may be the same, and materials of which the first barrier layer 41 and the second barrier layer 42 are made may also be the same. Optionally, the foregoing magnetic tunnel barrier may alternatively be of an asymmetrical structure. For example, sizes of the first barrier layer 41 and the second barrier layer 42 may be different, and materials of which the first barrier layer 41 and the second barrier layer 42 are made may also be different.

In this embodiment of this application, a new structure of a magneto-resistive random memory cell and a magneto-resistive random access memory is provided. In the structure, a double-barrier quantum well structure is used to replace a conventional single-barrier magnetic tunnel barrier structure, and the structure uses a feature of negative differential resistance of the double-barrier quantum well. A voltage of a write operation may be set to be greater than that of a read operation, to meet a requirement of optimizing performance of the write operation. In addition, because a current corresponding to the voltage of the read operation is relatively large, and a corresponding resistance value is relatively small, impact of the RC delay on a speed of the read operation is alleviated.

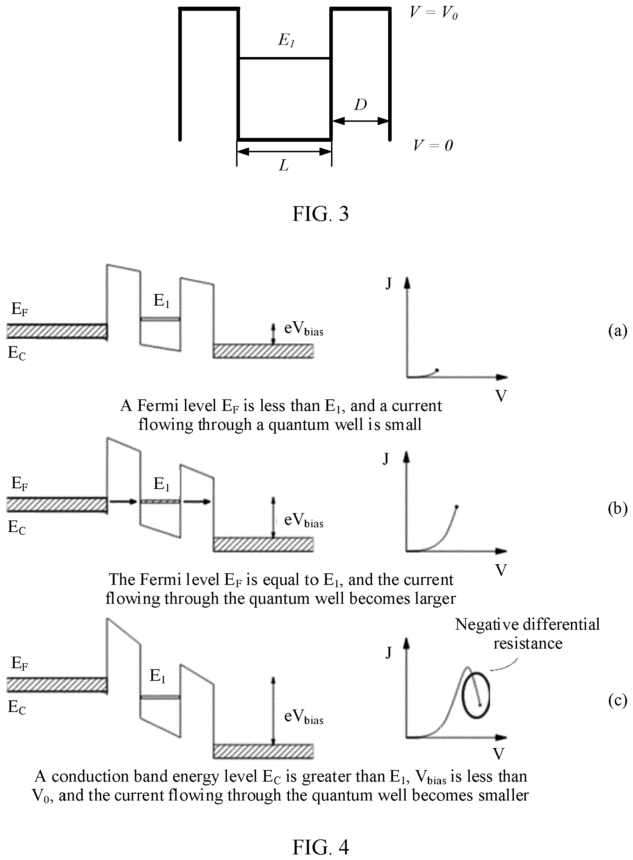

Specifically, FIG. 3 is a schematic diagram of distribution of energy levels of a double-barrier quantum well. As shown in FIG. 3, the quantum well is a quantum well with a limited barrier height. It is assumed that a barrier height is V₀, a barrier width is D, and a width of the quantum is L. Magnitudes and distribution of quantum well energy levels may be adjusted based on the barrier height V₀ of the quantum well, the barrier width D of the quantum well, and the width L of the quantum well. Energy levels in the quantum well are distributed discontinuously. Therefore, energy of carriers (for example, electrons) in the quantum well is also distributed discontinuously. In an example, it is assumed that a lowest energy level of the quantum well is E₁.

FIG. 4 shows voltage-current characteristic curves of a double-barrier quantum well. E_{F} in FIG. 4 represents a Fermi level of electrons, and E_{C} represents a conduction band energy level. E₁ represents the lowest energy level of the quantum well. eV_{bias} represents band bending corresponding to the voltage V_{bias} applied to the two ends of the quantum well, J represents a density of the current flowing through the double-barrier quantum well, and V_{bias} represents the voltage applied to the two ends of the double-barrier quantum well.

As shown in (a) of FIG. 4, when the voltage V_{bias} applied to the two ends of the double-barrier quantum wellis relatively low, the Fermi level E_{F} is less than the energy level E₁, the current flowing through the quantum well is relatively small, and a resistance value is relatively large.

As shown in (b) of FIG. 4, when the voltage V_{bias} applied to the two ends of the double-barrier quantum wellincreases, the Fermi level E_{F} is greater than the energy level E₁, and the conduction band bottom edge energy level E_{C} is less than the energy level E₁. In this case, the current flowing through the quantum well becomes larger, and the resistance value becomes smaller.

As shown in (c) of FIG. 4, when the voltage V_{bias} applied to the two ends of the double-barrier quantum wellcontinues increasing, both the Fermi level E_{F} and the conduction band bottom edge energy level E_{C} are greater than the energy level E₁, and V_{bias} is less than V₀. In this case, the current flowing through the quantum well becomes smaller, and the resistance value becomes larger. Therefore, it can be learned from (c) of FIG. 4 that a voltage-current characteristic of the quantum well is presented as negative differential resistance.

In addition, when the voltage V_{bias} applied to the two ends of the double-barrier quantum wellcontinues increasing, V_{bias} is greater than the barrier height V₀. In this case, the current flowing through the quantum well starts to become larger again, and the resistance value becomes smaller.

Therefore, it can be learned from the foregoing analysis that the voltage-current characteristic of the double-barrier quantum wellis nonlinear. For example, the current in (b) of FIG. 4 is relatively large, and the voltage V_{bias} is relatively small. However, the current in (c) of FIG. 4 is relatively small, and the voltage V_{bias} is relatively large. Therefore, the voltage V_{bias} in (b) of FIG. 4 may be set to a voltage of a write operation, and the voltage V_{bias} in (c) of FIG. 4 may be set to a voltage of a read operation. Because the voltage-current characteristic of the double-barrier quantum wellis nonlinear, a voltage of a write operation may be set to be greater than that of a read operation, to meet a requirement of optimizing performance of the write operation. In addition, because a current corresponding to the voltage of the read operation is relatively large, and a corresponding resistance value is relatively small, impact of the RC delay on a speed of the read operation is alleviated.

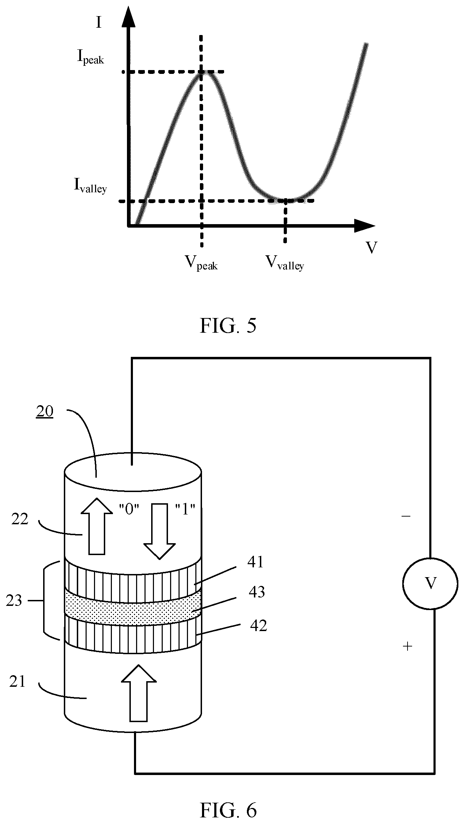

FIG. 5 shows a voltage-current characteristic curve of a double-barrier quantum well according to another embodiment of this application. A horizontal coordinate V represents a voltage applied to two ends of a double-barrier quantum well, and a vertical coordinate represents a current flowing through the quantum well. As shown in FIG. 5, before the voltage V applied to the two ends of the quantum well causes breakdown of the quantum well, it is assumed that a maximum current is Iₚₑₐₖ, and a voltage corresponding to the maximum current is Vₚₑₐₖ; and a minimum current is I_{valley}, and a voltage corresponding to the minimum current is V_{valley}. Optionally, V_{valley} may be set to an optimal voltage of a write operation, and Vₚₑₐₖ may be set to an optimal voltage of a read operation. It is assumed that the write operation voltage is represented by V_{write}, and the read operation voltage is represented by V_{read}. In this case, the foregoing relationship may be expressed as V_{write}=V_{valley}, and V_{read}=Vₚₑₐₖ.

It may be understood that the foregoing values are merely an example rather than a limitation. For example, another appropriate value may be selected in an interval centered around V_{valley} for the write operation voltage, and another appropriate value may be selected in an interval centered around Vₚₑₐₖ for the read operation voltage.

FIG. 6 is a schematic diagram of a write operation of a magneto-resistive random memory cell according to an embodiment of this application. A hollow arrow in FIG. 6 represents a direction of a magnetic moment in a fixed ferromagnetic layer 21 or a free ferromagnetic layer 22. As shown in FIG. 6, for an operation of writing "0", a negative first voltage may be applied to a direction from the free ferromagnetic layer 22 to the fixed ferromagnetic layer 21. To be specific, the free ferromagnetic layer 22 is connected to a negative electrode of a power supply, and the fixed ferromagnetic layer 21 is connected to a positive electrode of the power supply. A magnitude of the first voltage may be, for example, V_{valley}, or another appropriate voltage value may be selected for the first voltage according to the description in FIG. 5. Similarly, for an operation of writing "1", a negative first voltage may also be applied to the direction from the free ferromagnetic layer 22 to the fixed ferromagnetic layer 21. A magnitude of the first voltage may be, for example, V_{valley}, or another voltage value may be selected for the first voltage according to the description in FIG. 5. It should be noted that, in both the operation of writing "0" and the operation of writing "1", directions of the voltage applied to the two sides of the magnetic tunnel junction are the same. Each time a write operation is performed, a magnetic moment of the free ferromagnetic layer may be reversed once, and a resistance value correspondingly becomes larger or smaller, so that a state of a memory cell is switched from "0" to "1" or from "1" to "0". A write operation voltage may be set to be greater than a read operation voltage by using a feature of negative differential resistance of the double-barrier quantum well. A large write operation voltage can increase a speed of a write operation, and reduce an error rate of the write operation, to implement a high-speed and low-energy voltage-controlled write operation.

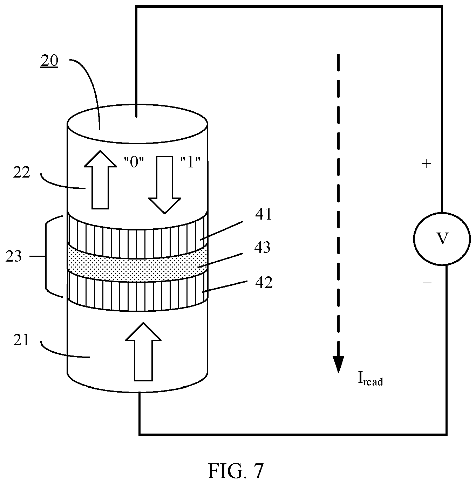

FIG. 7 is a schematic diagram of a read operation of a magneto-resistive random memory cell according to an embodiment of this application. A hollow arrow in FIG. 7 represents a direction of a magnetic moment in a fixed ferromagnetic layer 21 or a free ferromagnetic layer 22. A dashed line arrow in FIG. 7 represents a direction of a read operation current I_{read} flowing through the magneto-resistive random memory cell. As shown in FIG. 7, for a read operation, a positive second voltage may be applied to a direction from the free ferromagnetic layer 22 to the fixed ferromagnetic layer 21. To be specific, the free ferromagnetic layer 22 is connected to a positive electrode of a power supply, and the fixed ferromagnetic layer 21 is connected to a negative electrode of the power supply. A magnitude of the second voltage may be, for example, Vₚₑₐₖ, or another appropriate voltage value may be selected for the second voltage according to the description in FIG. 5. Selection of the read operation voltage may make a resistance value of a magnetic tunnel barrier relatively low, to alleviate impact of an RC delay on a reading speed, thereby providing a random access function of a high-speed read operation with a low RC delay.

In the embodiments of this application, a new magneto-resistive random access memory with a resonant tunneling effect is constructed by using a feature of negative differential resistance of a double-barrier quantum well. A magneto-resistive random access memory with high performance and a high storage density is provided by combining a high-speed voltage-controlled write operation with low power consumption and a high-speed read operation with a low RC delay.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A magneto-resistive random memory cell (20), comprising:
a fixed ferromagnetic layer (21);
a free ferromagnetic layer (22); and
a magnetic tunnel barrier (23), wherein the magnetic tunnel barrier (23) is located between the fixed ferromagnetic layer (21) and the free ferromagnetic layer (22), and comprises a first barrier layer (41), a conducting layer (43), and a second barrier layer (42),
wherein the first barrier layer (41) and the second barrier layer (42) are composed by a dielectric, and the conducting layer (43) is composed by a conducting material;
wherein
for a write operation of the magneto-resistive random memory cell a negative first voltage is to be applied to a direction from the free ferromagnetic layer (22) to the fixed ferromagnetic layer (21), and a magnetic moment of the free ferromagnetic layer (22) is reversed; and
for a read operation of the magneto-resistive random memory cell a positive second voltage is to be applied to a direction from the free ferromagnetic layer (22) to the fixed ferromagnetic layer (21), and a magnetic tunnel junction comprising the fixed ferromagnetic layer (21), the free ferromagnetic layer (22), and the magnetic tunnel barrier (23) is conducted, wherein an absolute value of the first voltage is greater than an absolute value of the second voltage.

2. The magneto-resistive random memory cell according to claim 1, wherein the first barrier layer (41) and the second barrier layer (42) are made of crystalline oxide.

3. The magneto-resistive random memory cell according to claim 1 or 2, wherein a material used for the first barrier layer (41) and the second barrier layer (42) comprises magnesium oxide, MgO, and a material used for the conducting layer comprises cobalt iron boron, CoFeB.

4. The magneto-resistive random memory cell according to any one of claims 1 to 3, wherein the magnetic tunnel barrier (23) is of a symmetrical structure.

5. A magnetoresistive random access memory comprising a magneto-resistive random memory cell according to any one of claims 1 to 4.

## Patentansprüche

1. Magnetoresistive Speicherzelle mit wahlfreiem Zugriff (20), die umfasst:
eine feste ferromagnetische Schicht (21);
eine freie ferromagnetische Schicht (22) und
eine magnetische Tunnelbarriere (23), wobei die magnetische Tunnelbarriere (23) sich zwischen der festen ferromagnetischen Schicht (21) und der freien ferromagnetischen Schicht (22) befindet und eine erste Barriereschicht (41), eine leitende Schicht (43) und eine zweite Barriereschicht (42) umfasst,
wobei die erste Barriereschicht (41) und die zweite Barriereschicht (42) durch ein Dielektrikum gebildet sind und die leitende Schicht (43) durch ein leitendes Material gebildet ist;
wobei
für einen Schreibvorgang der magnetoresistiven Speicherzelle mit wahlfreiem Zugriff eine negative erste Spannung an eine Richtung von der freien ferromagnetischen Schicht (22) zu der festen ferromagnetischen Schicht (21) anzulegen ist und ein magnetisches Moment der freien ferromagnetischen Schicht (22) umgekehrt wird; und
für einen Lesevorgang der magnetoresistiven Speicherzelle mit wahlfreiem Zugriff eine positive zweite Spannung an eine Richtung von der freien ferromagnetischen Schicht (22) zu der festen ferromagnetischen Schicht (21) anzulegen ist und die Leitung über einen magnetischen Tunnelkontakt, der die feste ferromagnetische Schicht (21), die freie ferromagnetische Schicht (22) und die magnetische Tunnelbarriere (23) umfasst, erfolgt, wobei ein Absolutwert der ersten Spannung größer als ein Absolutwert der zweiten Spannung ist.

2. Magnetoresistive Speicherzelle mit wahlfreiem Zugriff nach Anspruch 1, wobei die erste Barriereschicht (41) und die zweite Barriereschicht (42) aus kristallinem Oxid bestehen.

3. Magnetoresistive Speicherzelle mit wahlfreiem Zugriff nach Anspruch 1 oder 2, wobei ein Material, das für die erste Barriereschicht (41) und die zweite Barriereschicht (42) verwendet wird, Magnesiumoxid, MgO, umfasst und ein Material, das für die leitende Schicht verwendet wird, Kobalt-Eisen-Bor, CoFeB, umfasst.

4. Magnetoresistive Speicherzelle mit wahlfreiem Zugriff nach einem der Ansprüche 1 bis 3, wobei die magnetische Tunnelbarriere (23) eine symmetrische Struktur aufweist.

5. Magnetoresistive Speicher mit wahlfreiem Zugriff, die eine magnetoresistive Speicherzelle mit wahlfreiem Zugriff nach einem der Ansprüche 1 bis 4 umfasst.

## Revendications

1. Cellule de mémoire aléatoire magnéto-résistive (20), comprenant :
une couche ferromagnétique fixe (21) ;
une couche ferromagnétique libre (22) ; et
une barrière tunnel magnétique (23), dans laquelle la barrière tunnel magnétique (23) est située entre la couche ferromagnétique fixe (21) et la couche ferromagnétique libre (22), et comprend une première couche barrière (41), une couche conductrice (43) et une seconde couche barrière (42),
dans laquelle la première couche barrière (41) et la seconde couche barrière (42) sont constituées d'un diélectrique, et la couche conductrice (43) est constituée d'un matériau conducteur ;
dans laquelle
pour une opération d'écriture de la cellule de mémoire aléatoire magnéto-résistive, une première tension négative doit être appliquée dans une direction allant de la couche ferromagnétique libre (22) à la couche ferromagnétique fixe (21), et un moment magnétique pour la couche ferromagnétique libre (22) est inversé ; et
pour une opération de lecture de la cellule de mémoire aléatoire magnéto-résistive, une seconde tension positive doit être appliquée dans une direction allant de la couche ferromagnétique libre (22) à la couche ferromagnétique fixe (21), et une jonction de tunnel magnétique comprenant la couche ferromagnétique fixe (21), la couche ferromagnétique libre (22), et la barrière tunnel magnétique (23) est réalisée, dans laquelle une valeur absolue de la première tension est supérieure à une valeur absolue de la seconde tension.

2. Cellule de mémoire aléatoire magnéto-résistive selon la revendication 1, dans laquelle la première couche barrière (41) et la seconde couche barrière (42) sont constituées d'oxyde cristallin.

3. Cellule de mémoire aléatoire magnéto-résistive selon la revendication 1 ou 2, dans laquelle un matériau utilisé pour la première couche barrière (41) et la seconde couche barrière (42) comprend de l'oxyde de magnésium, MgO, et un matériau utilisé pour la couche conductrice comprend du cobalt-fer-bore, CoFeB.

4. Cellule de mémoire aléatoire magnéto-résistive selon l'une quelconque des revendications 1 à 3, dans laquelle la barrière tunnel magnétique (23) présente une structure symétrique.

5. Mémoire d'accès aléatoire magnéto-résistive comprenant une cellule de mémoire aléatoire magnéto-résistive selon l'une quelconque des revendications 1 à 4.
